Europäisches Patentamt

European Patent Office

Office européen des brevets

(11) Veröffentlichungsnummer: **0 185 181**
**B1**

(12) **EUROPÄISCHE PATENTSCHRIFT**

(45) Veröffentlichungstag der Patentschrift: 16.05.90

(51) Int. Cl.⁵: **H 03 K 17/08**

(21) Anmeldenummer: 85113936.0

(22) Anmeldetag: 02.11.85

(54) Induktionsarme Anoden-Kathodenbeschaltung eines abschaltbaren Leistungsthyristors.

(30) Priorität: 28.11.84 CH 5676/84

(43) Veröffentlichungstag der Anmeldung:
25.06.86 Patentblatt 86/26

(45) Bekanntmachung des Hinweises auf die
Patenterteilung:
16.05.90 Patentblatt 90/20

(84) Benannte Vertragsstaaten:
BE CH DE FR GB IT LI NL SE

(56) Entgegenhaltungen:
FR-A-2 251 119

ELEKTROTECHNIK, Band 65, Heft 4, Februar
1983, Seiten 14-17; W. BÖSTERLING et al.:
"Praxis mit dem GTO. Abschaltthyristoren für
selbstgeführte Stromrichter, Teil 2"

PATENTS ABSTRACTS OF JAPAN, Nr. 158
(E-186)1303r, 12. Juli 1983; & JP - A - 58 66 575
IEEE Transactions on Industry Applications, Vol.
IA-19, 3 (1983), p.343-347
The Bell System Technical Journal, Vol. 43, p.
2063 (1964)

(73) Patentinhaber: BBC Brown Boveri AG
Haselstrasse
CH-5401 Baden (CH)

(72) Erfinder: Egger, Claude
Prés-du Lac 16
CH-1400 Yverdon (CH)
Erfinder: Umbricht, Stefan
Bahnhofstrasse 44
CH-5430 Wettingen (CH)

**Beschreiben**

Bei der Erfindung wird ausgegangen von einer induktionsarmen Anoden-Kathodenbeschaltung eines abschaltbaren Leistungsthyristors nach dem Oberbegriff des Patentanspruchs 1.

Mit diesem Oberbegriff nimmt die Erfindung auf einen Stand der Technik von induktionsarmen Anoden-Kathodenbeschaltungen eines abschaltbaren Leistungsthyristors Bezug, wie er in IEEE Transactions on Industry Applications, Vol. IA-19, 3(1983) S. 343—347 beschrieben ist. Für Fahrzeugantriebe mit einer Leistung von 600 kVA werden dort zwei abschaltbare, sogenannte GTO-Thyristoren, die für 2500 V/1000 A ausgelegt sind, über Stromausgleichdrosseln parallelgeschaltet. Zu jedem GTO-Thyristor ist eine Diode antiparallel und ein Abschaltentlastungskreis, der aus einer Beschaltungsdiode parallel zu einem Widerstand und aus einem dazu in Reihe geschalteten Kondensator besteht, parallelgeschaltet. Hauptsächlich durch Streuinduktivitäten der Bauelemente und Leitungen des Abschaltentlastungskreises wird beim Abschalten des Thyristors an diesem ein steiler Spannungsanstieg mit einem Horn bzw. einer Impulszacke bewirkt, was zu einer Zerstörung des Thyristors führen kann. Zur Verringerung der Induktivität des Abschaltenlastungskreises werden induktionsarme Kondensatoren und Dioden sowie kurze Leitungen, insbesondere flexible Koaxlleitungen verwendet.

Die Erfindung, wie sie im Patentanspruch 1 definiert ist, löst die Aufgabe, eine Anoden-Kathodenbeschaltung für einen abschaltbaren Leistungsthyristor anzugeben, die eine geringere Streuinduktivität aufweist.

Ein Vorteil der Erfindung besteht in einer erhöhten Abschaltleistung bzw. in einem erhöhten zulässigen Abschaltstrom des Leistungsthyristors und in geringeren Schaltverlusten.

Mit der vorteilhaften Ausgestaltung der Erfindung gemäss Anspruch 2 wird eine Verringerung der Gesamtinduktivität des Abschaltentlastungskreises durch Verwendung mehrerer parallelgeschalteter, leistungsschwächerer und billigerer Dioden sowie kleinerer, induktivitätsärmerer Kondensatoren erreicht.

Ein Vorteil gemäss Anspruch 3 besteht in der gleichmässigen Belastung der Bauelemente des Abschaltentlastungskreises.

Die Anordnung der Bauelemente des Abschaltentlastungskreises gemäss Anspruch 4 gewährleistet einen übersichtlicheren Aufbau und eine rationelle Fertigung.

Die Ausgestaltung gemäss Anspruch 5 eignet sich besonders für hohe Spannungen und erlaubt die Verwendung von üblichen und billigeren Bauelementen, die für kleinere Spannungen ausgelegt sind.

Eine symmetrische Ausführung der elektrischen Anschlüsse von Dioden und Kondensatoren an die leitendenden Platten gemäss Anspruch 6 und 7 führt zu einer weiteren Verrringerung der Leitungsstreuinduktivitäten.

Die Erfindung wird nachstehend anhand von Ausführungsbeispielen erläutert. Es zeigen:

Fig. 1 ein Schaltbild einer Anoden-Kathodenbeschaltung eines abschaltbaren Leistungsthyristors,

Fig. 2 ein Spannungs- und Stromzeitdiagramm zur Erläuterung der Funktion des Schaltbildes gemäss Fig. 1,

Fig. 3 eine Anoden-Kathodenbeschaltung gemäss Fig. 1 mit mehreren parallelgeschalteten Beschaltungsdioden und -Kondensatoren,

Fig. 4a und 4b einen Plattenanschluss einer Beschaltungsdiode und eines -Kondensators gemäss Fig. 1 im Schnitt und in Draufsicht,

Fig. 4c—4f Prinzipdarstellungen unterschiedlicher Platten-Anschlussmöglichkeiten einer Beschaltungsdiode und eines -Kondensators,

Fig. 5a und 5b ein Prinzipschaltbild einer Reihenschaltung mehrerer Beschaltungsdioden und -Kondensatoren sowie eine dazugehörige Schaltung dieser Bauelemente mittels paralleler leitender Platten,

Fig. 6a eine Kreissektoranordnung von Leistungsthyristor, Beschaltungsdioden und -Kondensatoren in Draufsicht,

Fig. 6b eine vereinfachte Schnittdarstellung der Bauelementeanordnung längs einer Linie B—B in Fig. 6a und

Fig. 7 eine teilweise geschnittene, perspektivische Darstellung einer Anoden-Kathodenbeschaltung gemäss Fig. 3 mit parallelen leitenden Platten,

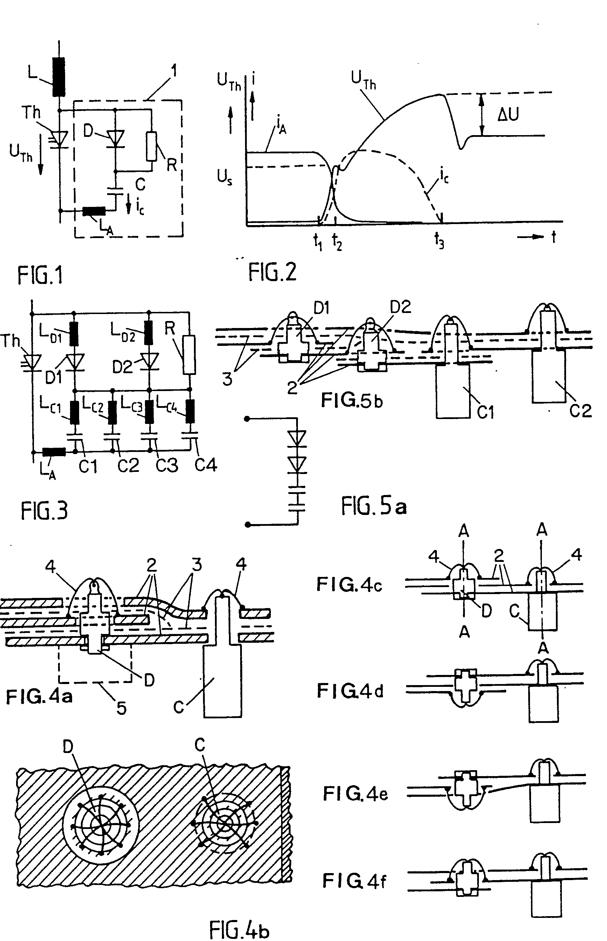

In Fig. 1 ist mit L eine Drossel zur Stromanstiegsbegrenzung bezeichnet, die mit einer Anode eines abschaltbaren bzw. GTO-Leistungsthyristors Th elektrisch verbunden ist. Parallel zum Leistungsthyristor Th ist eine Thyristorbeschaltung bzw. ein Abschaltentlastungskreis 1 angeschlossen. Der Abschaltenlastungskreis besteht aus einer Beschaltungsdiode D, die gleiche Polung wie der Leistungsthyristor Th aufweist, aus einem Widerstand R, der zur Beschaltungsdiode parallelgeschaltet ist, sowie aus einem Kondensator bzw. Beschaltungskondensator C, der zur Beschaltungsdiode D und zum Widerstand R in Reihe geschaltet ist. $L_A$ bezeichnet Streuinduktivitäten der Anschlüsse bzw. Zuleitungen zu den genannten Bauelementen, $i_c$ einen Auf- und Entladestrom des Kondensators C und $U_{Th}$ eine zwischen Anode und Kathode des Leistungsthyristors Th liegende Spannung.

In Fig. 2 sind die Anoden-Kathodenspannungs $U_{Th}$ des Leistungsthyristors Th und der Strom i bzw. der Anodenstrom $i_A$ des Leistungsthyristors Th und der Kondensatorstrom $i_c$ in willkürlichen Einheiten in Abhängigkeit von der Zeit t dargestellt. Im Abschaltzeitpunkt $t_1$ wird der Leistungsthyristor durch Anlegen einer einer negativen Gatespannung oder eines Gatestromes abgeschaltet. Der Anodenstrom $i_A$ des Leistungsthyristors Th fällt erst langsam, dann bis zu einem Zeitpunkt $t_2$ steil und schliesslich wieder langsam ab. Beim Abschalten kommutiert der Anodenstrom $i_A$ im wesentlichen auf einen Beschaltungspfad durch die Beschaltungsdiode D, den Kondensator C und die Streuinduktivität $L_A$, wobei der Strom $i_c$ zunächst stark ansteigt, nach Erreichen eines Maximums wider abnimmt und in einem Zeitpunkt $t_3$ den Wert Null erreicht. Durch die Stromänderung di/dt im Beschaltungspfad entsteht an $L_A$ kurzzeitig eine erste starke Spannungsänderung $dU_{Th}/dt$, die zu einem starken Anstieg der Anoden-Kathodenspannung $U_{Th}$ mit einem ersten Maximum bei einer Impulszackenspannung $U_S$ im Zeitpunkt $t_2$ führt. Nach einem geringen Spannungsabfall steigt die Anoden-Kathodenspannung $U_{Th}$ des Leistungsthyristors Th durch ein Aufladen des Kondensators C bis zu einem zweiten Maximum im Zeitpunkt $t_3$ an, um nach einem darauffolgenden Abfall auf einem nahezu konstantem Wert zu verharren.

Von besonderer Wichtigkeit ist eine Verringerung der zu $L_A$ proportionalen Impulszackenspannung $U_S$, da eine hohe Impulszackenspannung zu einer hohen Verlustleistung und damit zu einer hohen Wärmeentwicklung im Leistungsthyristor Th, insbesondere während de Zeitintervalls $t_2$-$t_1$, führt. Wenn die Impulszackenspannung $U_S$ einen kritischen Wert übersteigt, wird der Leistungsthryristor Th bei diesem Abschaltvorgang zerstört. Eine Verringerung der Impulszackenspannung $U_S$ bewirkt zudem eine Verrringerung der Schaltverluste im Leistungsthyristor Th. Aus diesen Gründen sollte die Streuinduktivität LA möglichst klein sein.

Eine Möglichkeit zur Verringerung der Streuinduktivität ist in Fig. 3 dargestellt. Dort sind zwei Beschaltungsdioden D1 und D2, die interne Streuinduktivitäten $L_{D1}$ und $L_{D2}$ aufweisen, parallelgeschaltet, so dass im Vergleich zur Verwendung nur einer Beschaltungsdiode D, entsprechend der in Fig. 1 dargestellten Schaltung, eine kleinere Streuinduktivität resultiert. Ausserdem sind vier Kondensatoren C1 ... C4, die interne Streuinduktivitäten $L_{C1}$ ... $L_{C4}$ aufweisen, parallelgeschaltet, von denen jeder Kondensator 1/4 der Sollkapazität des Abschaltentlastungskreises aufweist. Die Streuinduktivität dieser parallelgeschalteten Kondensatoren ist geringer als die Streuinduktivität nur eines Kondensators C mit Sollkapazität.

Eine Möglichkeit zur Verringerung der Streuinduktivität der Leitungsanschlüsee $L_A$ der Bauelemente ist aus Fig. 4 zu ersehen. Mit 2 sind im wesentlichen parallel zueinander verlaufende leitende Platten aus Kupfer, Aluminium oder einer gutleitenden, korrosionsbeständigen Legierung bezeichnet, mit 3 Isolationsschichten aus einem elektrisch isolierenden, korrosionsbeständigen Werkstoff, mit 4 Metalldrähte, welche die elektrischen Anschlussklemmen der Beschaltungsdiode D und des Beschaltungskondensators C mit entsprechenden leitenden Platten 2 elektrisch verbinden, und mit 5 ein Kühlkörper. der Kühlkörper 5 steht in gutem Wärmekontakt mit der Beschaltungsdiode D, vgl. Fig. 4a.

Fig. 4b zeigt die Plattenverbindung von Fig. 4a in Draufsicht. Für den elektrischen Anschluss der Bauelemente sind mehrere symmetrisch angeordnete Drähte 4 vorgesehen.

Die Fig. 4c bis 4f zeigen schematisch bezüglich Fig. 4a unterschiedliche Anschlussmöglichkeiten von Beschaltungsdiode D, Kondensator C und leitenden Platten 2, wobei der Einfachheit halber der Isolierungen 3 und der Kühlkörper weggelassen wurden. Wie bei den Fig. 4a und 4b weisen die Beschaltungsdiode D und der Kondensator C gemäss den Fig. 4c bis 4f die gleiche Achsrichtung A—A bezüglich ihrer räumlichen Gestalt auf. Im dargestellten Fall sind die Bauelemente zueinander achsparallel angeordnet.

Fig. 5a zeigt eine Serienschaltung mehrerer Beschaltungsdioden D und Kondensatoren C für hohe Spannungen und Fig. 5b eine dazugehörige Schaltungsmöglichkeit mit planparallelen leitenden Platten 2 und zwischengelagerten Isolationsschichten 3.

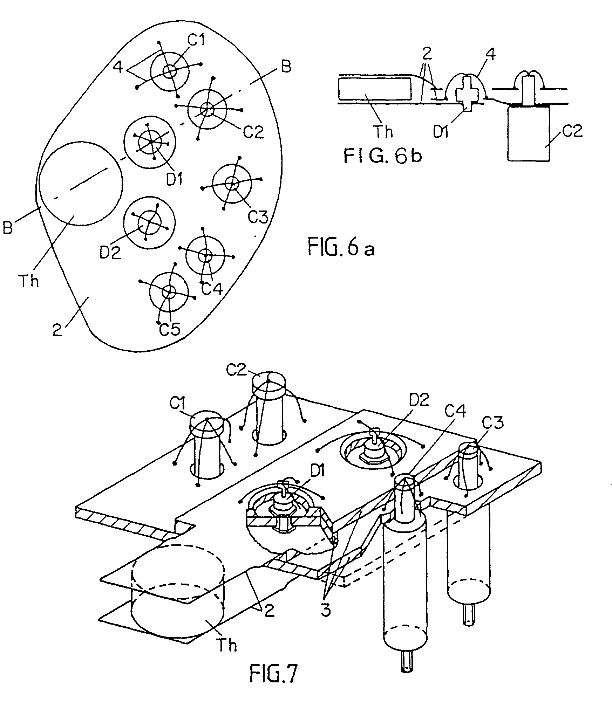

Gemäss Fig. 6a sind zwei Beschaltungsdioden D1, D2 sowie fünf Kondensatoren C1 ... C5 jeweils längs Kreislinien um den Leistungsthyristor Th in der Kreismitte angeordnet. Die leitenden Platten 2, von denen in Draufsicht nur die oberste dargestellt ist, sind kreisserktorförmig gestaltet. Fig. 6b zeigt die Anschlüsse der Bauelemente Th, D und C an leitende Platten 2 in einem Schnitt längs einer Schnittlinie B—B in Fig. 6a.

Bei der perspektivisch dargestellten Ausführung der Erfindung gemäss Fig. 7 sind vier Kondensatoren untereinander mittels leitender Platten 2 parallelgeschaltet und symmetrisch zu zwei ebenfalls parallelgeschalteten Beschaltungsdioden D1 und D2 angeordnet, entsprechend der Schaltung gemäss Fig. 3. Der tablettenförmige Leistungsthyristor Th, die Dioden D1, D2 und die Kondensatoren C1 ... C4 sind achsparallel zueinander ausgerichtet.

Die Beschaltungsdioden und die Kondensdatoren sind vorzugsweise induktivitätsarm aufgebaut. Weiterhin ist es vorteilhaft, bei den Bauelemente-Anordnungen gemäss den Fig. 4—7 anstelle der Drähte 4 glockenförmige, elektrisch gutleitende Kappen für die Anschlüsse der Kontaktklemmen der Beschaltungsdioden und -Kondensatoren an die leitenden Platten 2 zu verwenden. Mit diesen Massnahmen kann der Abschaltstrom des Leistungsthyristors Th im Vergleich zu der eingang genannten bekannten Beschaltung um etwa 30% erhöht werden.

**Patentansprüche**

1. Induktionsarme Anoden-Kathodenbeschaltung eines abschaltbaren Leistungsthyristors (Th)

a) mit mindestens einer Beschaltungsdiode (D) mit gleicher Polung wie der Leistungsthyristor,

b) zu der ein Kondensator (C) in Reihe geschaltet ist,

c) wobei diese Reihenschaltung aus Beschaltungsdiode und Kondensator zu dem Leistungsthyristor parallel geschaltet ist und

d) die elektrischen Anschlüsse (2, 4) zwischen Beschaltungsdiode, Kondensator und Leistungsthyristor induktionsarm ausgeführt sind,

e) wobei der Leistungsthyristor (Th), die mindestens eine Beschaltungsdiode (D) und der mindestens eine Kondensator (C) je eine geometrische Hauptachse bzw. Bauelement-Achsrichtung (A—A) und an entgegengesetzten Enden elektrische Anschlusselemente oder -kontakt-flächen aufweisen, dadurch gekennzeichnet,

f) dass der Leistungsthyristor (Th), die mindestens eine Beschaltungsdiode (D, D1, D2) und der mindestens eine Kondensator (C, C1 ... C5) durch elektrisch leitende Platten (2) miteinander elektrisch verbunden sind, welche Platten gegenseitig elektrisch isoliert sind und wenigstens abschnittsweise parallel zueinander verlaufen, und

g) dass der abschaltbare Leistungsthryistor (Th), die Beschaltungsdioden (D, D1, D2) und Kondensatoren (C, C1 ... C5) achsparallel zueinander angeordnet sind, wobei die Bauelemente Achsrichtung (A—A) im wesentlichen senkrecht zu dem sie verfindenden elektrisch leitenden Platten (2) ist.

2. Induktionsarme Anoden-Kathodenbeschaltung nach Anspruch 1 dadurch gekennzeichnet, dass die Anoden-Kathodenbeschaltung mehrere parallelgeschaltete Beschaltungsdioden (D, D1, D2) und/oder mehrere parallelgeschaltete induktionsarme Kondensatoren (C, C1 ... C5) aufweist.

3. Induktionsarme Anoden-Kathodenbeschaltung nach Anspruch 2, dadurch gekennzeichnet, dass untereinander parallelgeschaltete Beschaltungsdioden (D, D1, D2) und/oder Kondensatoren (C, C1 ... C5) der Anoden-Kathodenbeschaltung vom Leistungsthyristor (Th) gleichen Abstand aufweisen.

4. Induktionsarme Anoden-Kathodenbeschaltung nach Anspruch 3, dadurch gekennzeichnet, dass untereinander parallelgeschaltete Beschaltungsdioden (D, D1, D2) und/oder Kondensatoren (C, C1 ... C5) der Anoden-Kathodenbeschaltung längs Kreislinien um einen in Kreismitte befindlichen Leistungsthyristor (Th) angeordnet sind.

5. Induktionsarme Anoden-Kathodenbeschaltung nach einem der Ansprüche 1 bis 4, dadurch gekennzeichnet, dass mehrere Beschaltungsdioden (D, D1, D2) und/oder Kondensatoren (C, C1 ... C5) in Reihe geschaltet sind.

6. Induktionsarme Anoden-Kathodenbeschaltung nach einem der Ansprüche 2 bis 5, dadurch gekennzeichnet, dass die elektrischen Anschlüsse (4) zwischen den leitenden Platten (2) und den Beschaltungsdioden (D, D1, D2) und/oder den Kondensatoren (C, C1 ... C5) symmetrisch ausgebildet sind.

7. Induktionsarme Anoden-Kathodenbeschaltung nach einem der Ansprüche 2 bis 5, dadurch gekennzeichnet, dass die elektrischen Anschlüsse (4) zwischen den leitenden Platten (2) und den Beschaltungsdioden (D, D1, D2) und/oder den Kondensatoren (C, C1 ... C5) kappenförmig ausgebildet sind.

**Revendications**

1. Circuit anode-cathode à faible inductance d'un thyristor de puisance blocable (Th),

a) avec au moins une diode de connexion (D) avec la même polarité que le thyristor de puissance,

b) avec laquelle un condensateur (C) est monté en série,

c) ce montage en série formé de la diode de connexion et du condensateur étant monté en parallèle sur le thyristor de puissance, et

d) les connexions électriques (2, 4) entre la diode de connexion, le condensateur et le thyristor de puissance étant réalisées pour avoir une faible inductance, et

e) le thyristor de puissance (Th), la au moins une diode de connexion (D) et le au moins un condensateur (C) ayant en chaque cas un axe géométrique principal ou une direction d'axe de composant (A—A) et présentant des éléments de connexion électrique ou des surfaces de contact électrique à des extrémités opposées, caractérisé en ce que

f) le thyristor de puissance (Th), la au moins une diode de connexion (D, D1, D2) et le au moins un condensateur (C, C1, ..., C5) sont reliés électriquement entre eux par des plaques électriquement conductrices (2), lesquelles plaques sont isolées électriquement les unes par rapport aux autres et s'étendent parallèlement entre elles au moins par portions, et en ce que

g) le thyristor de puissance blocable (Th), les diodes de connexion (D, D1, D2) et les condensateurs (C, C1, ..., C5) sont disposés avec leurs axes parallèles entre eux, la direction A—A de l'axe de composants étants sensiblemeent perpendiculaire aux plaques électriquement conductrices (2) qui les relient.

2. Circuit anode-cathode à faible inductance selon la revendication 1, caractérisé en ce que le circuit anode-cathode comporte plusieurs diodes de connexion montées en parallèle (D, D1, D2) et/ou plusieurs condensateurs à faible inductance-montés en parallèle (C, C1, ..., C5).

3. Circuit anode-cathode à faible inductance selon la revendication 2, caractérisé en ce que les diodes de connexion (D, D1, D2) et/ou les condensateurs (C, C1, ..., C5) du circuit anode-cathode montés en parallèle entre eux, sont à la même distance du thyristor de puissance (Th).

4. Circuit anode-cathode à faible inductance selon la revendication 3, caractérisé en ce que les diodes de connexion (D, D1, D2) et/ou les condensteurs (C, C1, ..., C5) du circuit anode-cathode montés en parallèle entre eux sont disposés le long de lignes circulaires autour d'un thyristor de puissance (Th) se trouvant au centre du cercle.

5. Circuit anode-cathode à faible inductance selon l'une des revendications 1 à 4, caractérisé en ce que plusieurs diodes de connexion (D, D1, D2) et/ou condensateurs (C, C1, ..., C5) sont montés en série.

6. Circuit anode-cathode à faible inductance selon l'une des revendications 2 à 5, caractérisé en ce que les connexions électriques (4) entre les plaques conductrices (2) et les diodes de connexion (D, D1, D2) et/ou les condensateurs (C, C1, ..., C5) sont réalisées d'une façon symétrique.

7. Circuit anode-cathode à faible inductance selon l'une des revendications 2 à 5, caractérisé en ce que les connexions électriques (4) entre les plaques conductrices (2) et les diodes de connexions (D, D1, D2) et/ou les condensateurs (C, C1, . . ., C5) sont réalisées en forme de capuchon.

## Claims

1. Low-inductance anode-cathode R—C circuit of a gate-turn-off power thyristor (Th)

a) comprising at least one R—C circuit diode (D) of the same polarity as the power thyristor,

b) which is connected in series with a capacitor (C),

c) this series circuit of R—C circuit diode and capacitor being connected in parallel with the power thyristor, and

d) the electric connections (2, 4) between the R—C circuit diode, capacitor and power thyristor being of low-inductance construction

e) the power thyristor (Th), the at least one R—C circuit diode (D) and the at least one capacitor (C) each exhibiting a geometric main axis or axial component direction (A—A) and electric connecting elements or contact areas at opposite ends, characterized in

f) that the power thyristor (Th), the at least one R—C circuit diode (D, D1, D2) and the at least one capacitor (C, C1 . . . C5) are electrically connected to one another by electrically conductive plates (2), which plates are mutually electrically insulated and extend parallel to one another at least section by section, and

g) that the gate-turn-off power thyristor (Th), the R—C circuit diodes (D, D1, D2) and capacitors (C, C1 . . . C5) are arranged to be axially parallel to one another, the axial component direction (A—A) being essentially perpendicular to the electrically conductive plates (2) connecting them.

2. Low-inductance anode-cathode R—C circuit according to Claim 1, characterized in that the anode-cathode R—C circuit comprises several parallel-connected R—C circuit diodes (D, D1, D2) and/or several parallel-connected low-induction capacitors (C, C1 . . . C5).

3. Low-inductance anode-cathode R—C circuit according to Claim 2, characterized in that R—C circuit diodes (D, D1, D2) and/or capacitors (C, C1 . . . C5) which are connected in parallel with each other, of the anode-cathode R—C circuit are located at the same distance from the power thyristor (Th).

4. Low-inductance anode-cathode R—C circuit according to Claim 3, characterized in that R—C circuit diodes (D, D1, D2) and/or capacitors (C, C1 . . . C5), which are connected in parallel with each other, of the anode-cathode R—C circuit, are arranged along circular lines around a power thyristor (Th) which is located in the centre of the circle.

5. Low-inductance anode-cathode R—C circuit according to one of Claims 1 to 4, characterized in that several R—C circuit diodes (D, D1, D2) and/or capacitors (C, C1 . . . C5) are connected in series.

6. Low-inductance anode-cathode R—C circuit according to one of Claims 2 to 5, characterized in that the electric connections (4) between the conductive plates (2) and the R—C circuit diodes (D, D1, D2) and/or the capacitors (C, C1 . . . C5) are constructed to be symmetrical.

7. Low-inductance anode-cathode R—C circuit according to one of Claims 2 to 5, characterized in that the electric connections (4) between the conductive plates (2) and the R—C circuit diodes (D, D1, D2) and/or the capacitors (C, C1 . . . C5) are constructed to be cap-shaped.

FIG.1

FIG.2

FIG.3

FIG.5a

FIG.5b

FIG.4a

FIG.4b

FIG.4c

FIG.4d

FIG.4e

FIG.4f

FIG.6a

FIG.6b

FIG.7

2